# EUROPEAN PATENT APPLICATION

(11) **EP 4 378 881 A1**
(43) Date of publication of application: **05.06.2024**
(21) Application number: 22210906.8
(22) Date of filing: 01.12.2022
(51) Int. Cl.: B81B 7/00

(54) **MEMS PRESSURE TRANSDUCER CHIP WITH HYBRID INTEGRATED ENVIRONMENTAL BARRIER STRUCTURE AND METHOD FOR MANUFACTURING SAME**

(71) Applicant: Infineon Technologies AG, 85579 Neubiberg (DE)
(72) Inventor: WASISTO, Hutomo Suryo, 81541 München (DE); FÜLDNER, Marc, 85579 Neubiberg (DE); MAIER, Dominic, 92714 Pleystein (DE); WIESBAUER, Andreas, 9210 Poertschach (AT); ANZINGER, Sebastian, 83714 Miesbach (DE)
(74) Representative: Hersina, Günter

(57) **Abstract**

This disclosure concerns a method for manufacturing a MEMS pressure transducer chip (100) with a hybrid integrated environmental barrier structure (150), the method comprising a step of providing a substrate (110) comprising at least one membrane (120), a step of structuring a stepped recess structure (130) into the substrate (110), the stepped recess structure (130) comprising a first recess (131) having a first lateral width (W1) and an adjacent second recess (132) having a larger second lateral width (W2), wherein the stepped recess structure (130) extends between the membrane (120) and a substrate surface (142) opposite to the membrane (120), and a step of arranging an environmental barrier structure (150) inside the second recess (132). This disclosure also concerns a device being obtainable by said method.

## Description

Embodiments of the present disclosure relate to a microelectromechanical system (MEMS)-based pressure transducer chip with an integrated environmental barrier structure for protecting the membrane of the MEMS pressure transducer from interfering environmental substances (e.g., aerosols, salt particles, hairs, moisture (water droplets), oil, and other liquids).

### TECHNICAL BACKGROUND

A microelectromechanical system - MEMS - is a miniaturized system that comprises a very small form factor. For example, a pressure transducer may be provided as MEMS, wherein a small membrane may transduce its mechanical oscillations into electric signals, or vice versa. An example of a MEMS pressure transducer may be a tire pressure sensor that monitors the air pressure in tires. A further example may be a MEMS microphone that transduces sound waves (as an example of air pressure), such as music or voice, into electric signals, which can then be converted into digital data using an application-specific integrated circuit (ASIC). In the reverse direction, a MEMS speaker may convert digital data into sound by oscillating the membrane.

Owing to their miniaturized size, MEMS pressure transducers require environmental protection because they can be influenced by several physical and chemical interfering objects from the surrounding environment, in particular interfering environmental substances (e.g., aerosols, salt particles, hairs, moisture (water droplets), oil, and other liquids), which can then lead to lower robustness level and shorter operation time.

MEMS pressure transducer chips may be equipped with some external environmental barrier structures, like a mesh or a membrane. For example, the MEMS pressure transducer chip may be housed inside a MEMS package being arranged on a printed circuit board (PCB). A vent hole may be provided in the PCB for allowing environmental air pressure to enter the MEMS package. Currently, a mesh or a membrane may cover the vent hole, wherein it may be positioned inside or outside the MEMS package.

Despite its positioning flexibility when integrating the mesh or membrane with the package, this concept might result in additional effort and complexity for customers with respect to logistics and integration concepts, in particular if the environmental barrier has to be obtained from external suppliers. In case the environmental barrier is placed inside the MEMS package, the environmental barrier is normally glued between the MEMS chip and the PCB substrate. Otherwise, in case the environmental barrier is attached outside the MEMS package, additional laser processing has to be applied in order to create a cavity in the backside of the PCB substrate, in which the environmental barrier will be integrated. Both variants increase the packaging integration costs. Meanwhile, placing the environmental barrier directly outside the package without creating a laser-process pocket or cavity in the PCB substrate will result in not-flat or non-ideal surface structure of the package system leading to more complex integration in the later applications.

Furthermore, in case of MEMS microphones or speakers, the free space underneath the metal lid of the package defines the so-called back volume, which is essential for a good performance of the MEMS microphone or speaker. If the environmental barrier is placed inside the package underneath the lid, it consumes some of the available space, which leads to the reduction of the back volume.

Therefore, it would be desirable to equip a MEMS pressure transducer device with an environmental barrier without the above mentioned drawbacks.

This can be achieved by means of the herein disclosed MEMS pressure transducer chip and the corresponding method for fabricating the MEMS pressure transducer chip according to the independent claims. Further embodiments and advantageous aspects are suggested in the dependent claims.

One aspect concerns a method for manufacturing a MEMS pressure transducer chip with a hybrid integrated environmental barrier structure. The method comprises a step of providing a substrate comprising at least one membrane. The method further comprises a step of creating a stepped recess structure into the substrate, in which the stepped recess structure comprises a first recess having a first lateral width and an adjacent second recess having a larger second lateral width. The stepped recess structure extends between the membrane and a substrate surface opposite to the membrane. The method further comprises a step of arranging an environmental barrier structure inside the second recess.

A further aspect concerns a MEMS pressure transducer chip obtainable by said method. The MEMS pressure transducer chip comprises a substrate comprising at least one membrane. The substrate comprises a stepped recess structure, the stepped recess structure comprising a first recess having a first lateral width and an adjacent second recess having a larger second lateral width. The stepped recess structure extends between the membrane and a substrate surface opposite to the membrane. The MEMS pressure transducer chip further comprises an environmental barrier structure arranged inside the second recess.

In the following, embodiments of the present disclosure are described in more detail with reference to the figures, in which
- Fig. 1A: shows a schematic side view of a conventional MEMS pressure transducer package,
- Fig. 1B: shows a schematic side view of a further conventional MEMS pressure transducer package,
- Fig. 1C: shows a schematic side view of a further conventional MEMS pressure transducer package,
- Figs. 2A-2C: show schematic side views of a MEMS pressure transducer chip comprising a hybrid integrated environmental barrier structure according to an embodiment,
- Figs. 3: shows a schematic side view of a MEMS pressure transducer chip comprising a hybrid integrated environmental barrier structure according to an embodiment,
- Figs. 4A, 4B: show schematic side views of a MEMS pressure transducer chip with an additional monolithically integrated perforated mesh structure according to an embodiment,
- Figs. 5A-5G: show schematic side views of a process flow of a method for manufacturing an array of MEMS pressure transducer chips with hybrid integrated environmental barrier structures according to an embodiment,
- Fig. 6: shows a schematic side view of a MEMS pressure transducer package comprising a MEMS pressure transducer chip according to an embodiment, and
- Fig. 7: shows a block diagram for visualizing a method for manufacturing a MEMS pressure transducer chip comprising a hybrid integrated environmental barrier structure according to an embodiment.

### DESCRIPTION OF THE FIGURES

Equal or equivalent elements or elements with equal or equivalent functionality are denoted in the following description by equal or equivalent reference numerals.

Method steps, which are depicted by means of a block diagram and described with reference to said block diagram, may also be executed in an order different from the depicted and/or described order. Furthermore, method steps concerning a particular feature of a device may be replaceable with said feature of said device, and the other way around.

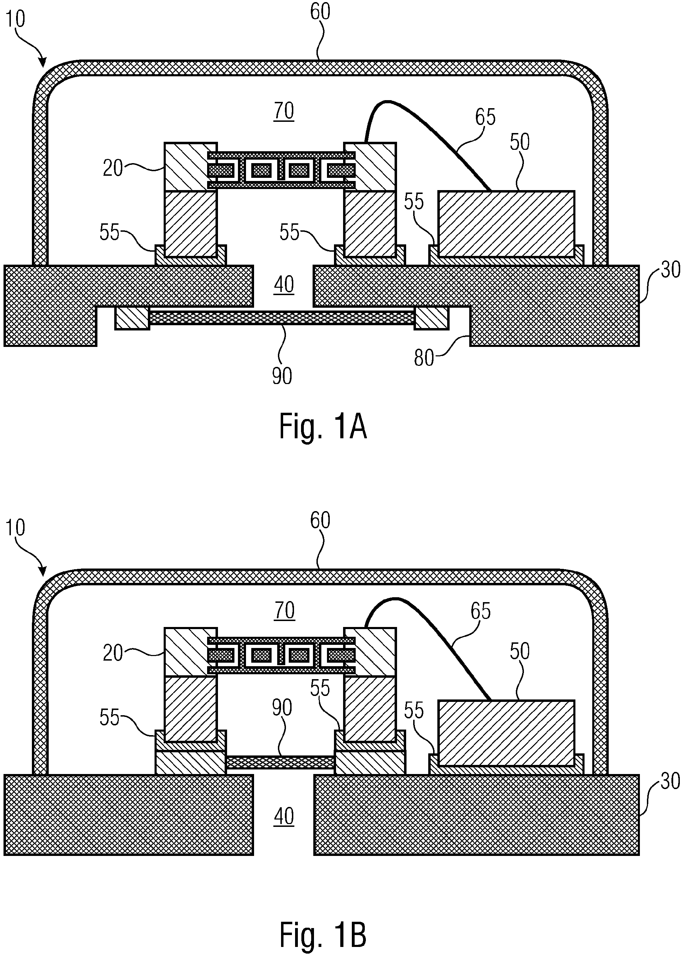

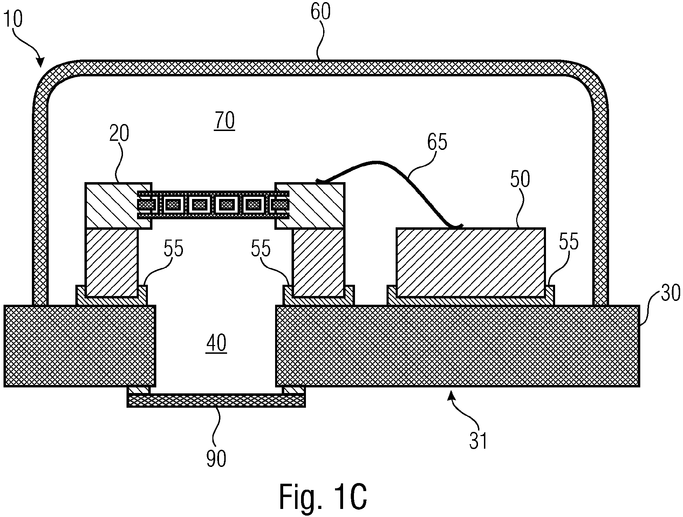

Figures 1A, 1B and 1C show examples of conventional MEMS pressure transducers comprising environmental barriers, as described in the introductory portion above. A MEMS package 10 includes a MEMS pressure transducer chip 20 being mounted on a PCB substrate 30. The PCB substrate 30 comprises a vent hole 40 through which ambient air or pressure waves may enter the MEMS package 10. An ASIC 50 is provided adjacent the chip 20. A lid 60 covers the chip 20 and the ASIC 50. The free space 70 underneath the lid 60 defines the back volume.

The ASIC 50 and the MEMS pressure transducer chip 20 are attached to the PCB substrate 30 by means of an adhesive layer 55. The ASIC 50 and the MEMS pressure transducer chip 20 may be electrically connected to each other by means of a bond wire 65.

As depicted in Figure 1A, the PCB substrate 30 comprises a cavity 80 being provided opposite to the lid 50. An environmental barrier 90 is integrated inside said cavity 80 and covers the vent hole 40. For creating the cavity 80 in the backside of the PCB substrate 30, additional laser processing or micromachining has to be applied.

Figure 1B shows an alternative, in which the environmental barrier 90 is positioned inside the package 10, i.e., in the free space 70 underneath the lid 60. Since the environmental barrier 90 consumes some amount of space, the back volume 70 is accordingly decreased by this amount leading to lower performance of the microphone.

Figure 1C shows a further alternative, in which the environmental barrier 90 is attached at the backside 31 (opposite to the lid 60) of the PCB substrate 30. In this case, the environmental barrier 90 may protrude from the outer contour of the package 10. Thus, the environmental barrier 90 is prone to damage.

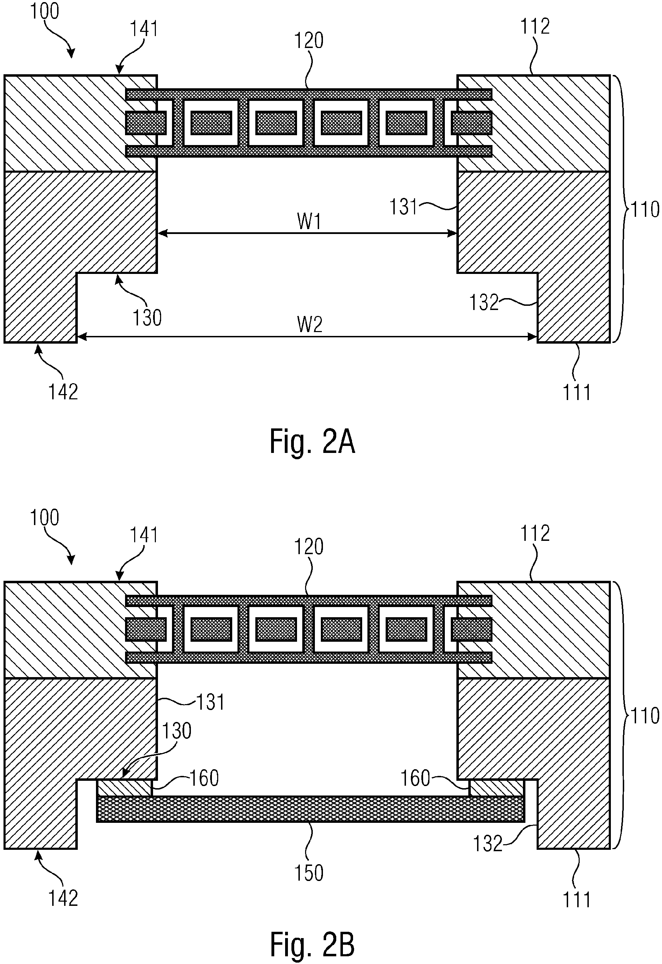

Figures 2A and 2B show embodiments of a MEMS pressure transducer chip 100 according to the herein disclosed innovative concept. The MEMS pressure transducer chip 100 comprises a substrate 110 comprising at least one membrane 120. The substrate 110 may optionally comprise one or more layers. For example, the substrate 110 may comprise a first layer 111 and a second layer 112. The first layer 111 may comprise semiconductor material, for example silicon. The second layer 112 may comprise or consist of a different material, e.g., tetraethyl orthosilicate, formally named tetraethoxysilane (TEOS). The membrane 120 may be provided in the second layer 112.

The substrate 110 further comprises a stepped recess structure 130, which may also be referred to as a double backside cavity. The stepped recess structure 130 may be provided in the first layer 111. The stepped recess structure 130 comprises a first recess 131, which may also be referred to as a first cavity. The stepped recess structure 130 comprises an adjacent second recess 132, which may also be referred to as a second cavity. The first recess 131 has a first lateral width W1, and the second recess 132 has a larger second lateral width W2.

The stepped recess structure 130 extends between the membrane 120 and a substrate surface 142 opposite to the membrane 120. Basically, the substrate 110 may comprise a first or top surface 141 and an opposite second or bottom surface 142. The membrane 120 may be positioned adjacent to the first surface 141. The stepped recess structure 130 may be provided adjacent to the second surface 142.

As can be seen in Figure 2B, the MEMS pressure transducer chip 100 further comprises an environmental barrier structure 150 being arranged inside the second recess 132. The environmental barrier structure 150 may be arranged inside the second recess 132 such that it covers the first recess 131.

The first recess 131 may be formed as a channel-like through hole vertically extending through the substrate 110 for allowing pressure waves to pass through the first recess 131 and to arrive at the membrane 120. Accordingly, the environmental barrier structure 150 may be arranged inside the second recess 132, hence it covers the through hole provided by the first recess 131. The environmental barrier structure 150 may act as a mechanical or physical barrier for preventing undesired particles, dust, moisture and the like from entering the MEMS pressure transducer chip 100, which could otherwise damage the membrane 120.

The environmental barrier structure 150 may be provided as a (semi-)permeable compliant membrane, or a rigid mesh structure, or a membrane-joint mesh structure. The environmental barrier structure 150 may be provided as a separate component that may be attached to the substrate 110. Thus, the environmental barrier structure 150 is a hybrid integrated environmental barrier structure. This is opposite to a monolithically integrated environmental barrier structure being directly structured into the substrate material 110.

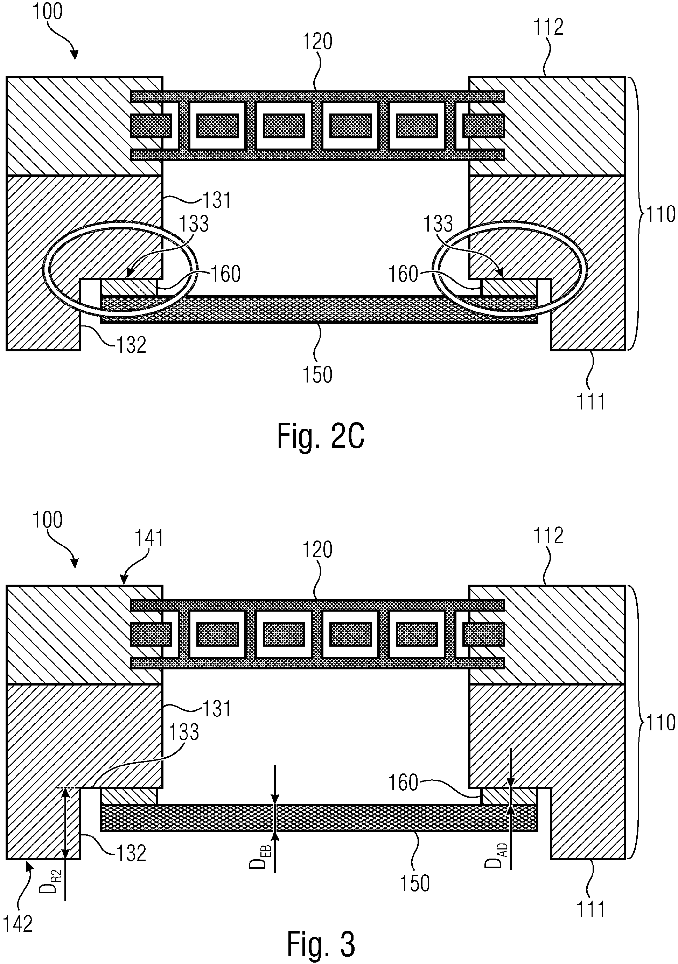

The environmental barrier structure 150 may be arranged inside the second recess 132 by means of an adhesive 160. As can be seen in Figure 2C, the environmental barrier structure 150 may be attached to a collar 133 that is formed by the transition between the first recess 131 and the adjacent second recess 132 (see encircled regions).

As depicted in Figure 3, the environmental barrier structure 150 may comprise a thickness D_{EB} that is measured perpendicular to its lateral extension. Furthermore, the second recess 132 may comprise a depth D_{R2} that is measured between the second, or bottom, surface 142 of the substrate 110 and the beginning of the first recess 131. More particular, the second recess 132 may comprise a depth D_{R2} that is measured between the second, or bottom, surface 142 of the substrate 110 and the aforementioned collar 133.

According to an embodiment, the depth D_{R2} of the second recess 132 may be as large as, or larger than, the thickness D_{EB} of the environmental barrier structure 150. In some embodiments, the depth D_{R2} of the second recess 132 may be as large as, or larger than, the thickness D_{EB} of the environmental barrier structure 150 including the thickness D_{AD} of the adhesive 160. Accordingly, the environmental barrier structure 150 may be completely received inside the second recess 132. In other words, the environmental barrier structure 150 does not protrude from the second, or bottom, surface 142 of the substrate 110.

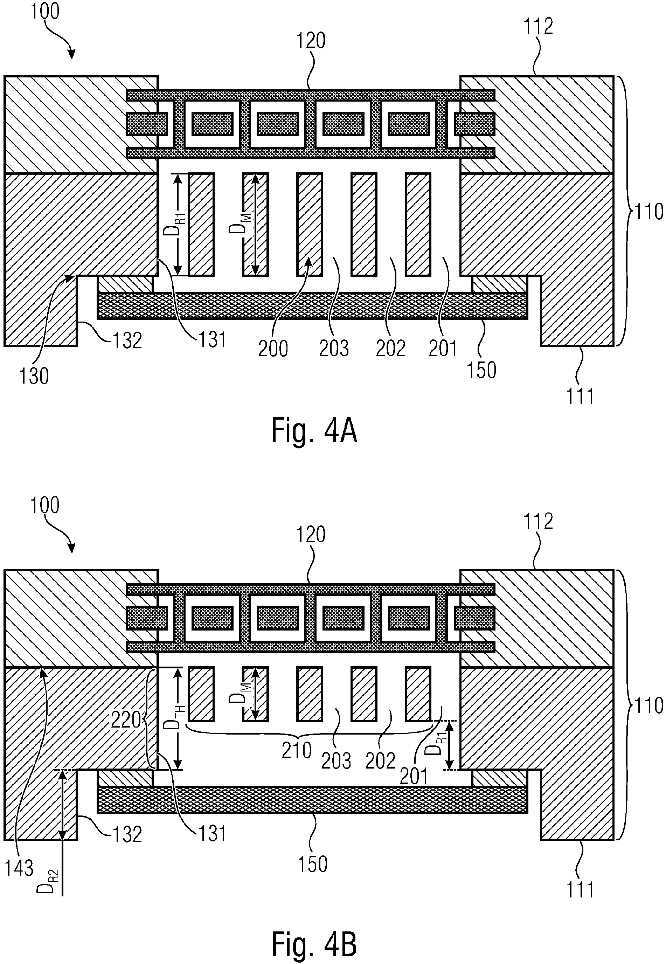

Figures 4A and 4B show further embodiments of the MEMS pressure transducer chip 100. Here, the pressure transducer chip 100 comprises a monolithically perforated mesh structure 200. The mesh structure 200 may be formed integrally, i.e. monolithically, with the substrate 110. In other words, the mesh structure 200 may be structured into the substrate material. For example, the monolithic perforated mesh structure 200 may be provided in the first layer 111 of the substrate 110.

The mesh structure 200 may be provided in the stepped recess structure 130, in particular in the first recess 131. As can be seen in Figure 4A, the first recess 131 may be created by structuring a plurality of perforations 201, 202, 203 into the substrate material. Accordingly, the remaining substrate material forms a monolithic perforated mesh structure 200 that resides inside the first recess 131. If the monolithic perforated mesh structure 200 is created in this manner, the mesh structure 200 comprises a thickness D_{M} that is as large as the depth D_{R1} of the first recess 131, as shown in Figure 4A. Alternatively, but not explicitly shown, the thickness D_{M} of the mesh structure 200 may by either smaller or larger than the depth D_{R1} of the first recess 131. In any case, the thickness D_{M} may influence the mechanical robustness of the mesh structure 200.

The monolithically perforated mesh structure 200 of this embodiment can be created by a two-step etching process, for example by a two-step RIE or DRIE etching process (RIE: Reactive Ion Etching / DRIE: Deep Reactive Ion Etching). A first etching step may be used for etching the above mentioned plurality of perforations 201, 202, 203 into the substrate 110. The size (e.g., diameter) of the perforations 201, 202, 203 may be varied in said first etching step. In result, the first recess 131 is not created as an obstruction-less channel-like through hole, as mentioned above, but the first recess 131 is created as a through hole with an additional integrated perforated mesh structure 200. In this case, the depth of the through hole may correspond to the depth D_{R1} of the first recess 131. Accordingly, the thickness D_{M} of the mesh structure 200 may be as large as the depth of the vent hole, as depicted in Figure 4A.

Figure 4B shows an alternative approach of creating a thinner monolithic perforated mesh structure 200 which is thinner than the depth of the through hole. Here, a three-step etching process, for example a three-step RIE or DRIE etching process, may be used for creating the mesh structure 200. In a first etching step the first recess 131 may be created, in a second etching step the second recess 132 may be created and in a third etching step the monolithic perforated mesh structure 200 may be created. The first, second and third etching steps may be performed sequentially in an arbitrary order.

Compared to the embodiments shown in Figures 2A to 2C and 3, the first recess 131 may be structured into the substrate 110 such that it does not extend completely through the substrate 110. Instead, the first recess 131 may be structured into the substrate 110 only by a predetermined depth such that a substrate portion 210 remains between the first recess 131 and the membrane 120. In other words, the first recess 131 is structured into the substrate 110 as a cavity that is closed at one end. Accordingly, at this stage, air cannot pass through the first recess 131 yet.

As can be seen in Figure 4B, a plurality of perforations 201, 202, 203 may be structured into said remaining substrate portion 210 being located between the first recess 131 and the membrane 120. Thereby, the monolithically perforated mesh structure 200 may be created between the first recess 131 and the membrane 120. When the perforations 201, 202, 203 are structured into the remaining substrate portion 210 for creating the mesh structure 200, environmental air can pass through the first recess 131 and the mesh structure 200. Accordingly, a channel-like through hole 220 is now formed through which environmental air can pass and enter the MEMS pressure transducer chip 100.

More particular, a channel-like through hole 220 may be created with an additional integrated perforated mesh structure 200. Here, the depth D_{TH} of the through hole 220 is larger than the thickness D_{M} of the mesh structure 200. For comparison, the depth D_{R1} of the first recess 131 and the depth D_{R2} of the second recess 132 are also exemplarily depicted in Figure 4B.

The above mentioned through hole 220 may be defined as a portion of the substrate 110 extending between the collar 133 (at the step or transition between the first and second recesses 131, 132) and an upper surface 143 of the first substrate layer 111. Said upper surface 143 may correspond to the surface facing the second substrate layer 112.

In both variants, as they are shown in Figures 4A and 4B, respectively, an additional (D)RIE process step may be performed to create the monolithically perforated mesh structure 200, wherein the duration of the applied process step can be adjusted to result in either a thick mesh structure (Figure 4A) or a thin mesh structure (Figure 4B).

The above discussed monolithic perforated mesh structure 200 may be advantageous since it may provide for an additional environmental barrier. Additionally or alternatively, the monolithically perforated mesh structure 200 may provide a mechanical stop in case of a deflectable environmental barrier structure 150, for example if the environmental barrier structure 150 is provided as a flexible and thus deflectable membrane with high compliance. In case the environmental barrier structure 150 is deflectable, the perforated mesh structure 200 may be monolithically integrated in the MEMS sound transducer chip 100 to act as a stopping layer for the environmental barrier structure 150.

For example, the mesh structure 200 may be rigid so as to avoid overbending of the deflectable environmental barrier structure 150, which may either damage the MEMS membrane 120 or deform the environmental barrier structure 150 itself, for example after being exposed to high air pressure or being immersed in water (e.g., depending on its deflection characteristic, the environmental barrier structure 150 may be overbent and may not return to its initial form and position). Thus, the perforated mesh structure 200 may also be referred to as a mesh based stopping-layer. As mentioned above, the thickness D_{M} of the mesh structure 200 can be adjusted during the etching process to create either a thicker or a thinner mesh structure 200.

Summarizing, the embodiment as shown in Figure 4A may comprise a thick monolithically integrated perforated mesh structure 200, which may comprise a thickness D_{M} that is as large as, or even larger than, the depth D_{R1} of the first recess 131. In turn, the embodiment as shown in Figure 4B may comprise a thinner monolithically integrated perforated mesh structure 200, which may comprise a thickness D_{M} that is smaller than the depth D_{TH} of the through hole 220. The embodiment according to Figure 4A may be fabricated by using a two-step RIE or DRIE process. The embodiment according to Figure 4B may be fabricated by using a three-step RIE or DRIE process.

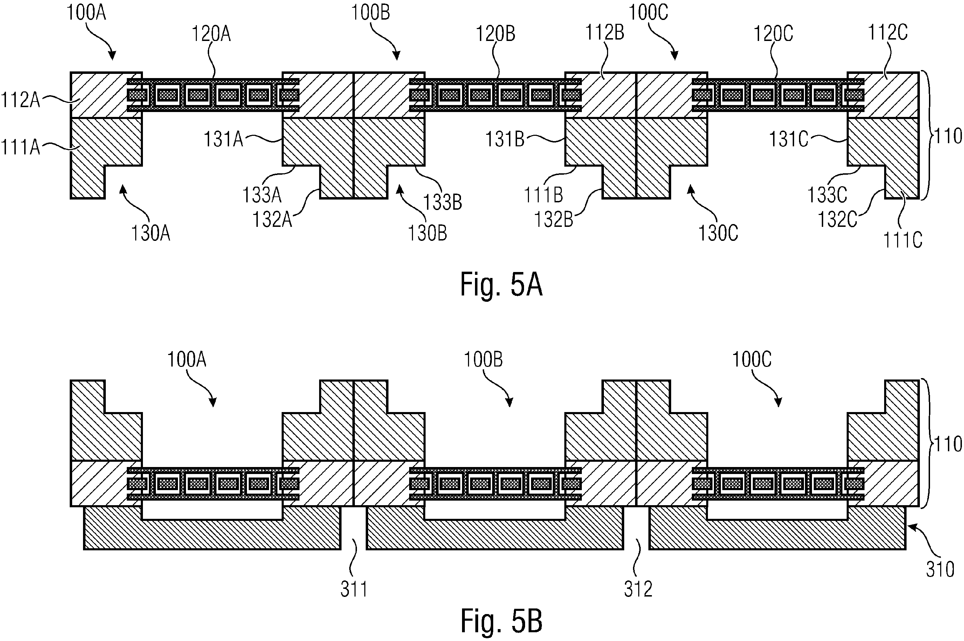

Figures 5A to 5G show some exemplary method steps of fabricating a MEMS pressure transducer chip 100 according to an embodiment. For ease of illustration, the MEMS pressure transducer chip 100 shown in Figures 5A to 5G does not comprise one of the above described monolithically integrated perforated mesh structures 200. However, it may also be possible that such a perforated mesh structure 200 may additionally be created in one of the steps of the process chain as shown in Figures 5A to 5G.

The method as described with reference to Figures 5A to 5G is performed on wafer level. Accordingly, the substrate 110 may be a wafer from which a plurality of MEMS pressure transducer chips 100A, 100B, 100C can be created.

Figure 5A shows a first method step, wherein a plurality of MEMS pressure transducer chips are formed from a wafer substrate 110. In this non-limiting example, three connected MEMS pressure transducer chips 100A, 100B, 100C are shown, which are formed from a wafer substrate 110. However, a lot more than the exemplarily depicted three MEMS pressure transducer chips 110A, 100B, 100C may be formed from the wafer substrate 110. The plurality of chips may also be referred to as a chip array. The wafer substrate 110 may comprise a first layer 111 and a second layer 112. Accordingly, each of the MEMS pressure transducer chips 100A, 100B, 100C may comprise a first substrate layer 111A, 111B, 111C and a second substrate layer 112A, 112B, 112C.

Each MEMS pressure transducer chip 100A, 100B, 100C may comprise a stepped recess structure 130A, 130B, 130C being provided in the wafer substrate 110, and in particular in the second substrate layer 112. The stepped recess structures 130A, 130B, 130C may each comprise a first recess 131A, 131B, 131C and a larger or wider second recess 132A, 132B, 132C.

The stepped recess structure 130A, 130B, 130C, i.e., each of the first recesses 131A, 131B, 131C and the second recesses 132A, 132B, 132C, may be structured into the wafer substrate 110 by using a two-step etching process, such as a two-step RIE or DRIE process. In this case, the first recess 131A, 131B, 131C may be etched in a first etching step, and the second recess 132A, 132B, 132C may be etched in a second etching step.

Instead of using an etching process, the stepped recess structure 130A, 130B, 130C may be created by a two-step material removal micromachining process, e.g., by drilling, milling, grinding, laser ablation or the like. In this case, the first recess 131A, 131B, 131C may be created in a first step, and the second recess 132A, 132B, 132C may be created in a second step.

Etching processes may be preferred over physical micromachining processes since each one of the plurality of chips on a single wafer can be processed simultaneously. Meanwhile, for the micromachining method (e.g., laser processing), each one of the plurality of chips on a single wafer need to be processed sequentially, i.e. one after the other, which may result in longer processing time and higher fabrication cost.

Irrespective of whether etching or micromachining is used for creating the stepped recess structure 130A, 130B, 130C, the above discussed monolithically integrated perforated mesh structure 200 may additionally be provided here. For example, the thicker mesh structure 200 of Figure 4A may be created during formation of the first recess 131A, 131B, 131C, as described above. In turn, the thinner mesh structure 200 of Figure 4B may be created in a third step, wherein the first recesses 131A, 131B, 131C and the second recesses 132A, 132B, 132C are created in the first and second steps, while the perforated mesh structure 200 is created in a third step. In case etching is used, all the chips on a single wafer can be processed simultaneously. Depending on the size of the processed wafer and the used etching machine, the holding plate inside the etching chamber may be able to be employed for placing more than one wafer. However, in the common industry standard way, wafers containing a number of chips may be processed sequentially (i.e., one wafer is processed after the other), possibly in an arbitrary order.

Since Figure 5A exemplarily shows MEMS pressure transducer chips 100A, 100B, 100C without any monolithically integrated perforated mesh structures 200, a two-step or double structuring process (e.g., RIE or DRIE process) may be used for creating the stepped recess structures 130A, 130B, 130C comprising the first recesses 131A, 131B, 131C and the second recesses 132A, 132B, 132C and the above discussed collars 133A, 133B, 133C, at which the environmental barrier structure will be later attached in a hybrid fashion. As an alternative technique, laser micromachining may be used for creating the stepped recess structures 130A, 130B, 130C. However, the laser micromachining has a drawback, in which the chips have to be processed sequentially one by one. Despite the possibility to introduce more than one laser source during the micromachining process, this method leads to higher fabrication cost. In turn, using an etching process instead, the first recesses 131A, 131B, 131C and the second recesses 132A, 132B, 132C on the chip arrays can be created simultaneously.

Figure 5B shows a step of flip and alignment of the wafer 110 onto a wafer carrier 310. Here, the MEMS pressure transducer chips 100A, 100B, 100C are flipped and aligned onto the wafer carrier 310 comprising vacuum holes 311, 312 for sucking and fixing the wafer 110 during wafer handling, e.g., during any of the subsequent steps like attaching the hybrid environmental barrier structure. In this step (Figure 5B), different materials may be used for the wafer carrier 310, such as metal, glass, silicon, porous ceramic, or Teflon^{®}.

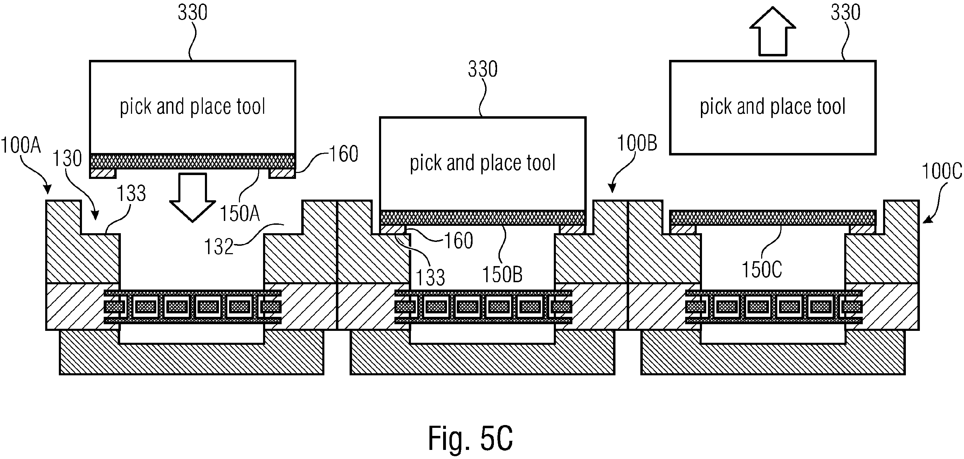

Figure 5C shows a further method step, in which the environmental barrier structures 150A, 150B, 150C are attached sequentially to the MEMS pressure transducer chips 100A, 100B, 100C, e.g., by means of a pick and place tool 330.

As can be seen on the left side of Figure 5C, the pick and place tool 330 may pick and carry a hybrid environmental barrier structure denoted with reference numeral 150A. The pick and place tool 330 may align the hybrid environmental barrier structure 150A with the collar 133 formed in the stepped recess structure 130 of each MEMS pressure transducer chip 100A, 100B, 100C. The environmental barrier structure 150A may comprise a bonding means (e.g., an adhesive) 160 at a surface facing the collar 133 formed in the stepped recess structure 130.

As shown in the middle of Figure 5C, the pick and place tool 330 may place the environmental barrier structure, here denoted with reference numeral 150B, onto the collar 133 such that the adhesive 160 is adhered to the collar 133. Accordingly, the step of arranging the environmental barrier structures 150A, 150B, 150C inside the second recess 132 may comprise a step of applying a bonding means 160 at a rim area of the environmental barrier structures 150A, 150B, 150C and attaching the environmental barrier structures 150A, 150B, 150C with the applied bonding means 160 directly to the substrate material.

Since the environmental barrier structures 150A, 150B, 150C are prepared with an adhesive carrier 160 at their rim, the environmental barrier structures 150A, 150B, 150C can be directly attached to the substrate material (e.g., silicon) without dispensing additional glue inside the stepped recess structure 130. Here, some parameter adjustments may be observed to precisely integrate the environmental barrier structure 150B without damaging the MEMS pressure transducer chips 100A, 100B, 100C, which may include geometry, applied force, and speed of the pick and place technique.

As depicted on the right side of Figure 5C, the pick and place tool 330 may be released and removed once the environmental barrier structure, here denoted with reference numeral 150C, is attached to the MEMS pressure transducer chips 100A, 100B, 100C.

The environmental barrier structures 150A, 150B, 150C may be provided as a flexible compliant membrane, a rigid mesh, or combination of both depending on the desired environmental robustness requirements/properties. Materials that may be used for the environmental barrier structures 150A, 150B, 150C may include, but are not limited to, different polymers (e.g., polytetrafluoroethylene (PTFE), polyacrylonitrile (PAN), polyvinylidene difluoride (PVDF), and polyimide), carbon, silicon, metal oxide, nitride, and two-dimensional (2D) materials (e.g., graphene and platinum diselenide (PtSe₂)). The environmental barrier structures 150A, 150B, 150C can be either provided in plain or nanostructured form.

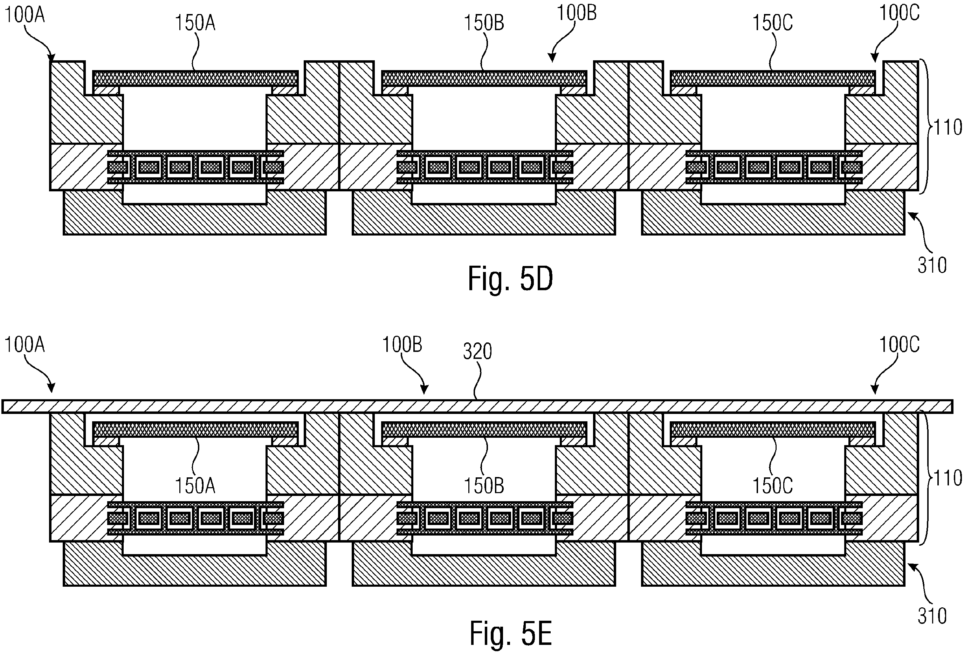

Figure 5D shows an array of MEMS pressure transducer chips 100A, 100B, 100C, each having the hybrid integrated environmental barrier structures 150A, 150B, 150C attached. The wafer 110 is now ready to be transferred to a lamination treatment.

Figure 5E shows a step of wafer lamination onto a foil 320. Here, the wafer 110 comprising the MEMS pressure transducer chips 100A, 100B, 100C, each being equipped with the environmental barrier structures 150A, 150B, 150C, may optionally be laminated onto a foil 320, while the wafer 110 may still be fixed to the vacuum wafer carrier 310.

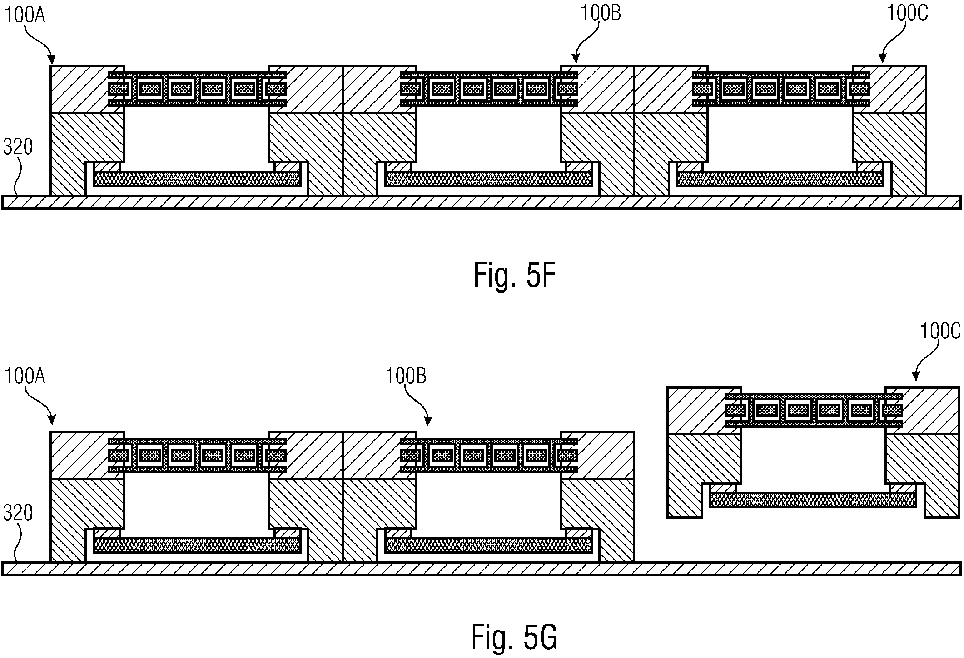

Figure 5F shows a further method step in which the laminated wafer 110 is released from the wafer carrier 310. After the wafer 110 has been completely laminated, the wafer vacuum carrier 310 may be removed. In Figure 5F the wafer 110 is vertically flipped by 180°.

Figure 5G shows a step of singulating the laminated MEMS pressure transducer chips 100A, 100B, 100C, e.g., by dicing, for yielding single MEMS dies. The singulated MEMS pressure transducer chips 100A, 100B, 100C are then ready to be completely released from the laminating foil 320 during the pick and place process. Here, only the MEMS pressure transducer chips 100A, 100B, 100C are separated, while the laminating foil 320 will remain on its place. The singulated (e.g., diced) MEMS pressure transducer chips 100A, 100B, 100C may then be placed onto a PCB using a pick-and-place tool for creating a MEMS pressure transducer package.

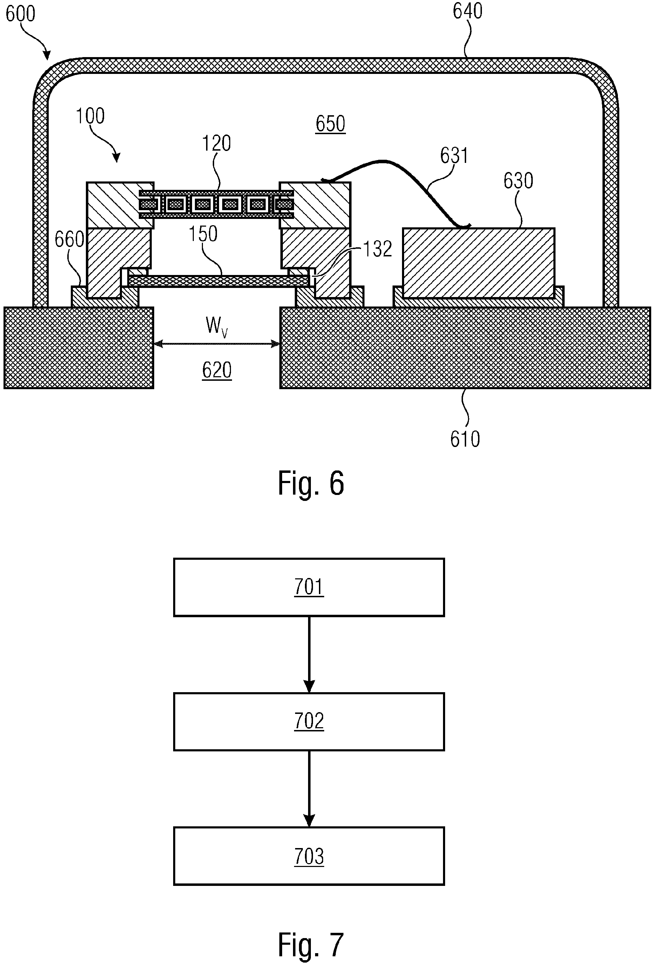

Figure 6 shows a MEMS pressure transducer package 600 comprising a MEMS pressure transducer chip 100 as described herein. The package 600 comprises a component substrate 610, e.g., a printed circuit board (PCB) substrate. A circuitry 630, e.g., an application-specific integrated circuit (ASIC), may be arranged adjacent to the MEMS pressure transducer chip 100. The circuitry 630 and the MEMS pressure transducer chip 100 may be electrically connected to each other via a bond wire 631. A metal lid 640 may be placed on the component substrate 610, such that it covers the MEMS pressure transducer chip 100 and the circuitry 630. In case the MEMS pressure transducer chip 100 is configured as a MEMS microphone, the cavity or space 650 underneath the lid 640 may be referred to as a back volume.

The component substrate 610 may comprise a vent hole 620 through which ambient air or pressure waves from the environment may pass and enter the back volume 650 underneath the lid. Additionally or alternatively, a vent hole may be provided in the lid 640. In case the MEMS pressure transducer chip 100 is configured as a MEMS microphone, the vent hole 620 may be referred to as a sound port.

The MEMS pressure transducer chip 100 may be attached to the component substrate 610, such that it covers the vent hole 620. In particular, the MEMS pressure transducer chip 100 may be arranged such that the hybrid integrated environmental barrier structure 150 faces the vent hole 620. Thus, the environmental barrier structure 150 may prevent undesired particles, dust, moisture and the like, that may have passed through the vent hole 620, from reaching the membrane 120 of the MEMS pressure transducer chip 100.

The vent hole 620 may comprise a width Wv that is smaller, or as large as, the width W₂ of the second recess 132 (Figure 2A). Thus, the environmental barrier structure 150 may completely cover the vent hole 620 for securely protecting the MEMS pressure transducer chip 100 from ingress of foreign matters.

Though not explicitly shown, the MEMS pressure transducer chip 100 may optionally comprise a monolithically integrated perforated mesh structure 200 as discussed above with reference to Figures 4A and 4B.

It is an advantage of the above described packaging concept that only one pick-and-place step has to be performed on PCB level, since the environmental barrier structure 150 is hybrid integrated into the MEMS pressure transducer chip 100. In conventional systems, as shown in Figures 1A and 1B, the environmental barrier 90 is provided as a discrete component that is separate from the MEMS chip 20. Thus, one pick-and-place step has to be performed for placing the environmental barrier 90 at the PCB 30, and one further pick-and-place step has to be performed for placing the MEMS chip 20 at the PCB 30. Furthermore, as shown in Figure 1B, the discrete environmental barrier 90 consumes some amount of space underneath the lid 60, which reduces the available back volume.

In turn, since embodiments of the herein described innovative concept provide for a hybrid integrated environmental barrier structure 150, there is no loss of back volume, i.e., the same back volume as compared to bare MEMS dies can be maintained (particularly the distance between the MEMS membrane 120 with the inner part of the metal lid 640).

As can further be seen in Figure 6, the bottom part of the MEMS pressure transducer chip 100 may be attached to the component substrate 610 (e.g., PCB) using a bonding means 660, for instance at least one of glue, adhesive, or Elastosil^{®}. As can be seen at the inside of the second recess 132, a rim region of the flipped environmental barrier structure 150 may also be connected and supported by the same bonding means 660, which potentially leads to more stable and robust anchoring of the environmental barrier structure 150.

Figure 7 shows a block diagram of a method as described herein, i.e., a method for manufacturing a MEMS pressure transducer chip 100 with a hybrid integrated environmental barrier structure 150. Some method steps may comply with the method steps as discussed above with reference to Figures 5A to 5G, while some of the above described methods steps may rather be optional.

In block 701, a substrate 110 is provided, the substrate 110 comprising at least one membrane 120.

In block 702, a stepped recess structure 130 is structured into the substrate 110, the stepped recess structure 130 comprising a first recess 131 having a first lateral width W₁ and an adjacent second recess 132 having a larger second lateral width W₂, wherein the stepped recess structure 130 extends between the membrane 120 and a substrate surface 142 opposite to the membrane 120.

In block 703, an environmental barrier structure 150 is arranged inside the second recess 132.

Summarizing, the herein described innovative concept suggests a method for manufacturing a MEMS pressure transducer chip 100 with an hybrid integrated environmental barrier structure 150, as well as for a device being obtainable by said method. This concept is called hybrid because the employed environmental barrier structure 150 may be fabricated separately as a discrete component/device (i.e., not monolithically integrated in the MEMS chip 100). The discrete environmental barrier structure 150 may be hybrid integrated into the MEMS pressure transducer chip 100. For instance, the environmental barrier structure 150 may be directly attached to the second cavity 132 resulting in a straightforward integration process at a later packaging stage. The second cavity 132 may be created using e.g., reactive ion etching (RIE), laser micromachining, or other physical/chemical microprocessing techniques. In terms of RIE, inductively coupled plasma (ICP) cryogenic or Bosch RIE process can be opted.

The stepped recess structure 130 comprising the two recesses 131, 132 (also referred to as backside-cavities) may provide a pocket/holder for the discrete environmental barrier structure 150. The first recess 131 may either be a conventional cylindrical Bosch hole (Figures 2A-3, and 5A-6), or it may comprise a multitude of smaller sized holes 201, 202, 203 forming a mesh structure 200 that may act as a stopper for large deflections of the environmental barrier structure 150 (Figures 4A and 4B).

This concept can be applied not only in sealed dual membrane (SDM) technology, but also in single backplate (SBP), double-backplate (DBP), and other possible MEMS-based membrane technologies that have semiconductor materials (silicon) or other (e.g., glass) as a substrate 110 to be structured using double or triple backside etching process or other physical/chemical micromachining techniques.

The herein described innovative concept provides for MEMS pressure transducer chips 100 (e.g., MEMS microphone chips) with a hybrid integrated environmental barrier structure 150 directly on a wafer 110 during delivery. Thus, during manufacturing and assembly, it can be refrained from additional complicated integration steps like stacking of the environmental barrier structure 150 and the MEMS pressure transducer chip 100 on a PCB (Figure 1B). The herein discussed innovative packaging concept and procedure at the back-end-of-line (BEOL) can be set to be similar or same as in conventional MEMS pressure transducer production without any environmental barriers. In this case, when the above described wafer 110 comprising the hybrid integrated environmental barrier structure 150 is seen from top, its appearance will be similar to conventional wafers without environmental barriers. Therefore, existing production lines can be used.

The herein described innovative concept may have some further advantages, for example:
- Packaging process can be done in a simple way. Here, wafers can be produced with 'normal' appearance from the top view (one is supposed not being able to distinguish the difference between bare MEMS die and MEMS dies 100 comprising the hybrid integrated environmental barrier structure 150 when looking at them from top view with naked eyes). Thus, no additional effort is required to manage logistics and integration concepts of an environmental barrier structure 150, because the diced MEMS pressure transducer chips 100 having the hybrid integrated environmental barrier structure 150 can be treated exactly the same as its bare counterparts during its joining process in the metal lid.
- Existing back-volume can be well maintained. The back-volume of the herein described innovative MEMS pressure transducer chips 100 will be the same as that having bare MEMS dies. This will not be the case for the conventional approach as shown in Figure 1B (stacking the environmental barrier 90 between PCB 30 and MEMS chip 20), because in that case, the back-volume will be reduced.
- An optionally additional monolithically integrated perforated mesh structure 200 can increase the robustness of the MEMS pressure transducer chip 100. In the chip variants with integrated silicon mesh 200 (see Figures 4A and 4B), the mesh 200 can act as a stopping layer for the flexible environmental barrier structure 150 during its deflection. Hence, the MEMS membrane 120 can be protected if the environmental barrier structure 150 deflects to its maximum displacement. Moreover, this concept can avoid the possible overbending of the environmental barrier structure 150 under very high air pressure, which normally leads to its unreturnable deformation. These advantages will then increase the robustness or lifetime of both the environmental barrier structure 150 and the MEMS membrane 120.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A method for manufacturing a MEMS pressure transducer chip (100) with a hybrid integrated environmental barrier structure (150), the method comprising:
providing a substrate (110) comprising at least one membrane (120),
structuring a stepped recess structure (130) into the substrate (110), the stepped recess structure (130) comprising a first recess (131) having a first lateral width (W1) and an adjacent second recess (132) having a larger second lateral width (W2),
wherein the stepped recess structure (130) extends between the membrane (120) and a substrate surface (142) opposite the membrane (120), and
arranging an environmental barrier structure (150) inside the second recess (132).

2. The method of claim 1,
wherein the step of arranging the environmental barrier structure (150) inside the second recess (132) comprises
a step of attaching the environmental barrier structure (150) to a collar (133) that is formed by the transition from the first recess (131) to the adjacent second recess (132).

3. The method of claims 1 or 2,
wherein the step of arranging the environmental barrier structure (150) inside the second recess (132) comprises
a step of applying a bonding means (160) at a rim area of the environmental barrier structure (150), and attaching the environmental barrier structure (150) with the applied bonding means (160) directly to the substrate material.

4. The method of one of claims 1 to 3,
wherein the step of arranging the environmental barrier structure (150) inside the second recess (132) comprises
a step of arranging the environmental barrier (150) inside the second recess (132) such that it covers the first recess (131).

5. The method of one of claims 1 to 4,
wherein the step of structuring the stepped recess structure (130) into the substrate (110) comprises
a step of creating the second recess (132) with a depth (D_{R2}) that is as large as, or larger than, a thickness (D_{EB}) of the environmental barrier structure (150), such that the environmental barrier structure (150) is completely received inside the second recess (132).

6. The method of one of claims 1 to 5,
wherein the step of structuring the stepped recess structure (130) comprises creating the first recess (131) by structuring a plurality of perforations (201, 202, 203) into the substrate (110) for creating a monolithic perforated mesh structure (200) residing inside the first recess (131), said monolithic perforated mesh structure (200) having a thickness (D_{M}) that is as large as a depth (D_{R1}) of the first recess (131).

7. The method of one of claims 1 to 5,
wherein the step of structuring the stepped recess structure (130) comprises
structuring a plurality of perforations (201, 202, 203) into a substrate portion (210) located between the first recess (131) and the membrane (120) for creating a monolithic perforated mesh structure (200) between the first recess (131) and the membrane (120).

8. The method of one of claims 1 to 7,
wherein the step of structuring the stepped recess structure (130) comprises a two-step etching process, wherein the first recess (131) is etched in a first step, and the second recess (132) is etched in a second step.

9. The method of one of claims 1 to 7,
wherein the step of structuring the stepped recess structure (130) comprises a two-step material removal micromachining process, wherein the first recess (131) is created in a first step, and the second recess (132) is created in a second step,
wherein both micromachining steps are performed sequentially.

10. A MEMS pressure transducer chip (100) with a hybrid integrated environmental barrier structure (150), comprising:
a substrate (110) comprising at least one membrane (120),
the substrate (110) comprising a stepped recess structure (130), the stepped recess structure (130) comprising a first recess (131) having a first lateral width (Wi) and an adjacent second recess (132) having a larger second lateral width (W₂),
wherein the stepped recess structure (130) extends between the membrane (120) and a substrate surface (142) opposite the membrane (120), and
an environmental barrier structure (150) arranged inside the second recess (132).

11. The MEMS pressure transducer chip (100) of claim 10,
wherein the environmental barrier structure (150) being arranged inside the second recess (132) covers the first recess (131).

12. The MEMS pressure transducer chip (100) of claim 10 or 11,
further comprising a monolithic perforated mesh structure (200) residing inside the first recess (131),
wherein the first recess (131) comprises a depth (D_{R1}) that is as large as, or larger than, or smaller than a thickness (D_{M}) of the monolithic perforated mesh structure (200).

13. The MEMS pressure transducer chip (100) of one of claims 10 to 12,
wherein the environmental barrier structure (150) comprises at least one of a flexible membrane and a rigid mesh.

14. The MEMS pressure transducer chip (100) of one of claims 10 to 13,
wherein the MEMS pressure transducer chip (100) is a MEMS microphone chip comprising a flexible microphone membrane (120).

15. A MEMS pressure transducer package (600) comprising a housed MEMS pressure transducer chip (100) with a hybrid integrated environmental barrier structure (150) according to one of claims 10 to 14.
